# EUROPEAN PATENT SPECIFICATION

(11) **EP 0 449 481 B1**
(45) Date of publication and mention of the grant of the patent: **31.01.1996**
(21) Application number: 91302324.8
(22) Date of filing: 18.03.1991
(51) Int. Cl.: H05K 13/04

(54) **Component transporting apparatus and method**
Vorrichtung und Verfahren zum Transport von Bauteilen
Dispositif et méthode de transport de composants

(30) Priority: 19.03.1990 JP 68752/90; 18.05.1990 JP 126661/90
(43) Date of publication of application: 02.10.1991
(73) Proprietor: HITACHI, LTD., Chiyoda-ku, Tokyo 101 (JP)
(72) Inventor: Tomita, Masamichi, Chiyoda-mura, Niihari-gun, Ibaraki 315 (JP); Honma, Kazuo, Inashiki-gun, Ibaraki 300-03 (JP); Igarashi, Shigemi, Ushiki-shi, Ibaraki 300-12 (JP); Ishikawa, Tadaaki, Chiyoda-mura, Niihari-gun, Ibaraki 315 (JP); Takizawa, Ryu, Chiyoda-mura, Niihari-gun, Ibaraki 315 (JP); Hiramoto, Sotozi, Chiba-shi, Chiba 280 (JP); Honma, Makoto, Funabashi-shi, Chiba 274 (JP); Hata, Seiji, Fujisawa-shi, Kanagawa 251 (JP); Nakamura, Mitsuo, Sakura-shi,Chiba 285 (JP)
(74) Representative: Calderbank, Thomas Roger

(56) References cited:
- US-A- 4 608 494
- IBM TECHNICAL DISCLOSURE BULLETIN, vol. 31, no. 12, May 1989, pages 437-438,New York, US; "Closed-loop surface mount device imaging system"

## Description

The present invention relates to an apparatus and a method for transporting a component. It is particularly, but not exclusively, concerned with the transportation of an electronic component from a store of such components to a printed circuit board.

In general, when moving an electronic component from a store to a printed circuit board, so that the component can be mounted on that circuit board, the apparatus for transporting the component as a head which moves from a position in which it can pick up the component to a suitable position adjacent the printed circuit board. A suitable means, such as a nozzle, is provided on the head for holding the component. The positioning of the component on the printed circuit board then depends critically on the orientation of the component relative to the head; if the component is miss-aligned then it will not be positioned correctly. Therefore, several systems have been proposed to detect the position of the component relative to the head.

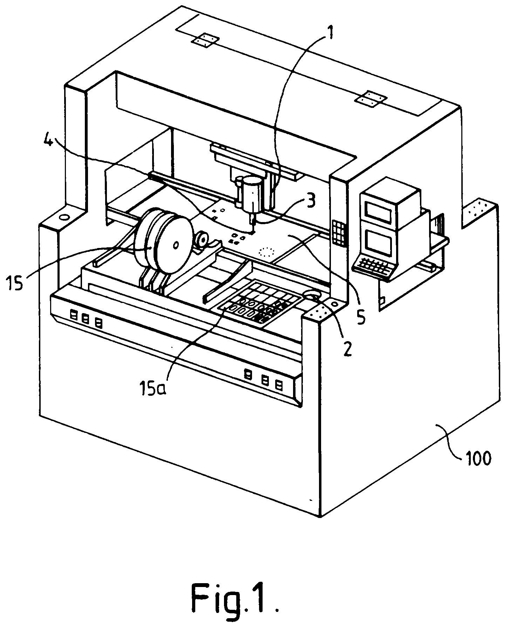

A first known apparatus is shown in Fig. 1 of the accompanying drawings. An adsorption nozzle 3 of a mounting head 1 of the electronic component mounting apparatus picks up an electronic component 4 from a component store 15 or 15a and the adsorption nozzle 3 moves to and stops at the position of an imaging apparatus 2. The imaging apparatus 2 detects the position of the electronic component 4 and decides whether or not the electronic component is in the correct position relative to the head 1, so that the component 4 can be mounted correctly on a printed circuit board 5. The imaging apparatus 2 is in the form of a camera and is located at a position below the path of movement of the adsorption nozzle 3.

A second known apparatus is disclosed in Japanese Patent Laid-Open No. 260280, 1988 which provides an imaging apparatus (camera) equipped with a position switch, a strobe and a high speed shutter at position below the path of movement of the head, so that when the head is located above the position switch, with an electronic component held thereon, the position switch operates, the strobe emits pulses light and the high speed shutter of the camera opens so as to take the photograph of the electronic component.

A third known apparatus is described in Japanese Patent Laid-Open No. 63099/1986. In this apparatus, the imaging apparatus (camera) is movable and when the head reaches a position above the printed circuit board, with an electronic component, the camera moves to a suitable position and takes a photograph of the electronic component and printed circuit board.

In the apparatus of Japanese Patent Laid-Open No. 63099 /1986, the camera as a tube extending therefrom, defining the optical path to the camera, which tube has a beam-splitter at the end of the tube remote from the camera, which enables the camera simultaneously to photograph both the component and the board. That end of the tube is therefore moved to a position directly between the component and the board, normally at equal distances from the component to the board, so that a suitable photograph can be taken.

A fourth known apparatus is disclosed in Japanese Patent Laid-Open No. 135403/1983. In this apparatus, a plurality of cameras are provided above the mounting head, to take photographs of the electronic component and the printed circuit board.

Other known proposals for detecting the position of the component relative to the head are disclosed in US 4286201, an article entitled "A Compact Image Processor and its Application" by S. Hacker et al. in the Proceedings of the 14th Annual Conference of IEEE Industrial Electronics Society, an article entitled "A Manufacturing Solution For Surface Mount Component High-Accuracy and High Volume Placement" by R. S. Shand in the Conference Proceedings of the Robots No. 12 and Vision 88 Conference, and an article entitled "Vision Applications of a Direct Drive Robot" by J. L. Morris in the 5th International Conference on Robot Vision and Sensory Controls.

The inventors of the present application have considered the known component transportation apparatuses described above, and have appreciated that they each suffer from defects, in use. In the first known apparatus, described with reference to Fig. 1. the head 1, on which the electronic component 4 is mounted, must stop when it moves to the position of the imaging apparatus (camera) 2. Moreover, since the head 1 does not move linearly to the position of the printed circuit board 5 but takes a roundabout route via the position of the imaging apparatus (camera) 2. the path of the head 1 contains a detour, so that the time for mounting the electronic component 4 onto the printed circuit board 5 is lengthened and the efficiency of mounting the electronic component is thus decreased.

The second known apparatus, of Japanese 260280/1988 does not suffer from problem described above because the imaging apparatus (camera) takes a photograph of the electronic component during the movement of the head. However, since the imaging apparatus (camera) is separate from the head, the applicants have found that blurring of the subject is likely to occur when the imaging apparatus (camera) detects the electronic component if there is any vibration or the like during the movement of the head, and detection at high accuracy is therefore difficult. To solve this problem, the mounting head must have a vibration-proofing structure and the structure is therefore more complicated.

The third known apparatus, of Japanese 63099/1986, does not suffer from the problem because the camera moves. However, since the imaging apparatus (camera) is integral with the optical components for imaging the electronic component and guiding the image to the imaging apparatus (camera), the camera and the optical components necessarily must be large, in order to detect a large sized electronic component, assuming that the visual field of the imaging apparatus (camera) is constant. Therefore, the time of movement of the imaging apparatus (camera) is long and in order to solve this problem, the force needed to drive the imaging apparatus (camera) must be increased.

IBM Technical Disclosure Bulletin Vol 31 No 12 Pages 437 to 438 discloses a closed-loop surface mount device imaging system.

The imaging system includes a camera fixed to a mirror and forms part of the head of a component transportation apparatus. The head of the apparatus is movable relative to the base and includes a holding means for holding a surface mount component so that movement of the head moves the component relative to the base. The imaging system can be moved relative to the rest of the head so that the mirror is moved to a position underneath the component and an optical path is defined between the component and the camera when the component is held by the holding means. Thus, this document corresponds to the pre-characterising part of claim 1. In this disclosure, the mirror is fixed relative to the camera.

The present invention seeks to provide an apparatus and method for transporting a component, such as an electronic component, which permits improved detection of the location of the component relative to the transportation head.

The present invention proposes that the imaging apparatus, which is preferably a camera, is provided on the head.

In the first aspect, the present invention provides an apparatus for transporting a component, comprising:
a base;
holding means for holding said component;
a head supporting the holding means, the head being connected and movable relative to said base in a first direction, thereby to cause transportation of said component relative to said base when said component is held by said holding means;
an imaging apparatus on said head for investigating said component optically when said component is held on said holding means; and
one or plurality of optical components on said head for defining an optical path between said imaging apparatus and said component when said component is held by said holding means;
wherein:
said imaging apparatus is fixed to said head, and said one or only one of said plurality of optical components is movable relative to said imaging apparatus between an operating position, in which said optical path is defined between said imaging apparatus and said component when said component is held by said holding means, and a withdrawn position in which said one or only one of said plurality of optical components does not interfere with processing of said component.

In this aspect the imaging apparatus is fixed to the head, and there is an optical component which is movable between a position in which it contributes to defining an optical path between the imaging apparatus and the component mounted on the head, and another position in which it is withdrawn. The imaging apparatus is fixed, and only the optical component moves relative to the head, the mechanism necessary for moving that optical component may be relatively simple. With such an arrangement, when the component is picked up by the head, the optical component is in its withdrawn position so it does not interfere with that picking up of that component, and it is then be moved to a position defining an optical path between the imaging apparatus and the component on the head, check that component is in the correct position relative to the head. Then, the optical component is withdrawn so that it does not subsequently interfere with the processing of the component, e.g. the mounting of that component on a printed circuit board.

A second imaging apparatus such as a camera having a wide angle of view for investigating the component when said component is held by the holding means may be provided. One camera has a narrow field of view and the other has a wide field of view. There are then a number of possibilities. Firstly, the two imaging apparatuses may be used to check the position of components of different sizes, so that the imaging apparatus with a narrow field of view detects small components where high precision is needed, and the imaging apparatus with a wide field of view detects large components. In this case, the imaging apparatus with the wide field of view may be on the head or on the base of the apparatus. If, however, the imaging apparatus with the wide field of view is positioned on the head, it could alternatively be used to detect the point to which the component on the head is to be moved, such as the printed circuit board.

The second imaging apparatus may however be mounted on the base of the apparatus. In this case the second imaging apparatus investigates the component when the component is on the holding means in a predetermined position relative to the base.

In a second aspect the present invention provides a method of transporting a component using a transportation apparatus comprising a base, a head movable connected to said base holding means on said head, and at least one optical component on said head, the method comprising:
holding said component on said holding means; and
moving said head relative to said base when said component is held by said holding means, thereby to transport said component;
wherein:
the imaging apparatus is fixed to the head; and
said method further includes:
moving said optical component relative to said imaging apparatus from a withdrawn position in which said optical component does not interfere with processing of said component to an operating position, in which operating position an optical path is defined between said imaging apparatus and said component;
investigating said component optically using said imaging apparatus; and
moving said optical component to said withdrawn position.

Embodiments of the present invention will now be described in detail, by way of example, with reference to the accompanying drawings, in which:
Fig. 1 shows a known apparatus for transporting an electronic component, and has already been described;
Fig. 2 is similar to Fig. 1, but the transportation apparatus of the present invention is incorporated therein;
Fig. 3 shows a first embodiment of a transportation apparatus according to the present invention;
Fig. 4 shows a second embodiment of the transportation apparatus according to the present invention;
Fig. 5 shows a third embodiment of the present invention;
Fig. 6 shows a fourth embodiment of the present invention;
Fig. 7 shows a fifth embodiment of the present invention;
Fig. 8 shows a sixth embodiment of the present invention;
Fig. 9 shows a seventh embodiment of the present invention;
Fig. 10 shows an eighth embodiment of the present invention;
Fig. 11 shows a ninth embodiment of the present invention;
Fig. 12 shows a tenth embodiment of the present invention;
Fig. 13 shows an eleventh embodiment of the present invention, and;
Fig. 14 shows a twelfth embodiment of the present invention.

### Detailed description

In the subsequent description, many components of the different embodiments are the same or similar, and in this case the same reference numerals are used to indicate corresponding parts.

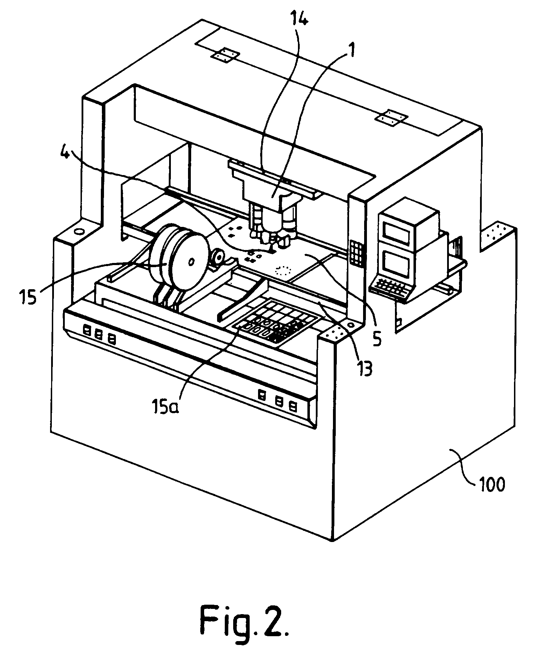

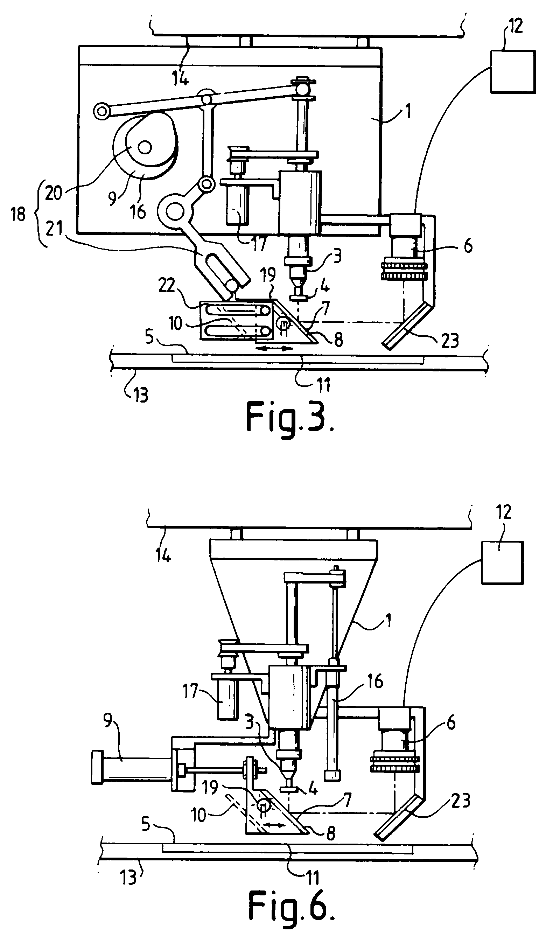

A first embodiment of the present invention will now be described with reference to Figs. 2 and 3.

Fig. 2 shows the overall construction of an electronic component transporting apparatus to which the present invention is applied. Various electronic components 4 are stored in the electronic component store device 15 (or in the component store 15a which will be discussed later). A printed circuit board 5 is fixed horizontally onto a conveyor 13. A head 1 is mounted over the board and is operated by a suspension type 2-axis cartesian co-ordinate robot 14 having its X- and Y-axes in a plane parallel to the surface of this printed circuit board 5, i.e. in a horizontal plane. One electronic component 4 is withdrawn from the electronic component store device 15 or 15A by adsorption due to suction by an adsorption nozzle 3 and the component is transferred to the printed circuit board 5. Fig. 2 shows that the apparatus has a base 100 which supports the other parts.

The construction of this embodiment is shown in more detail in Fig. 3. The head 1 supports the adsorption nozzle 3, a driving device 16 for moving vertically (in the Z axis) the nozzle 3, a driving device 17 for rotating the nozzle around its centre axis (Θ axis), an imaging apparatus (camera) 6, an optical component 8 which, in Fig. 3, lies on an extension of the axis of the nozzle 3 and which has a reflection surface 7, a driving device 9 for moving the optical component 8 relative to the imaging apparatus 6 and a transmission device 18. Furthermore, there is an illumination device 19 for illuminating the electronic component 4 near the optical component 8 or the nozzle 3.

In this embodiment, the driving device 16 for the vertical motion of the nozzle 3 and the driving device 9 for the relative motion of the optical component 8 are the same. Furthermore, a plane mirror inclined at 45° to the axis of the nozzle 3 is used as the optical component 8.

When the image of the electronic component 4 is taken, a cam 20 of the transmission device 18 is rotated by the operation of the driving device 9 on an instruction from a controller 12 of the electronic component transporting apparatus, a link mechanism 21 swings, slides the optical component 8 along a slide rail 22 and positions the reflection surface 7 previously on the extension of the axis of the nozzle 3 so as to define an optical path between the electronic component 4 and the imaging apparatus 6, via a second optical component 23 also having a reflection surface.

When the electronic component 4 is picked up from the electronic component supply device 15 or 15a and when it is mounted onto the printed circuit board 5, the driving device 9 operates similarly under instruction from the controller 12 of the electronic component mounting apparatus and withdraws the optical component 8 to a position clear of the extension of the axis of the nozzle 3, or in other words, it causes parallel motion in the horizontal direction. The nozzle 3 may then be lowered in synchronism with the parallel motion due to rocking of the link mechanism 21 described above and in this position a component 4 may by picked up by the nozzle 3 or mounted on the printed circuit board 5.

In this embodiment, the vertical motion of the adsorption nozzle 3 and the motion of the optical component 8 can be made in the interiocKing arrangement with each other by the same driving device. Therefore, both of these motions can be reliably synchronized and there is no possibility that the nozzle 3 and the optical component 8 will interfere with each other. Since the object which moves is the optical component 8, which is light in weight and since its operation stroke is small, a rapid, reciprocating motion can be made at the time of imaging and this is very effective for reducing the time for mounting the component 4 on the board 5.

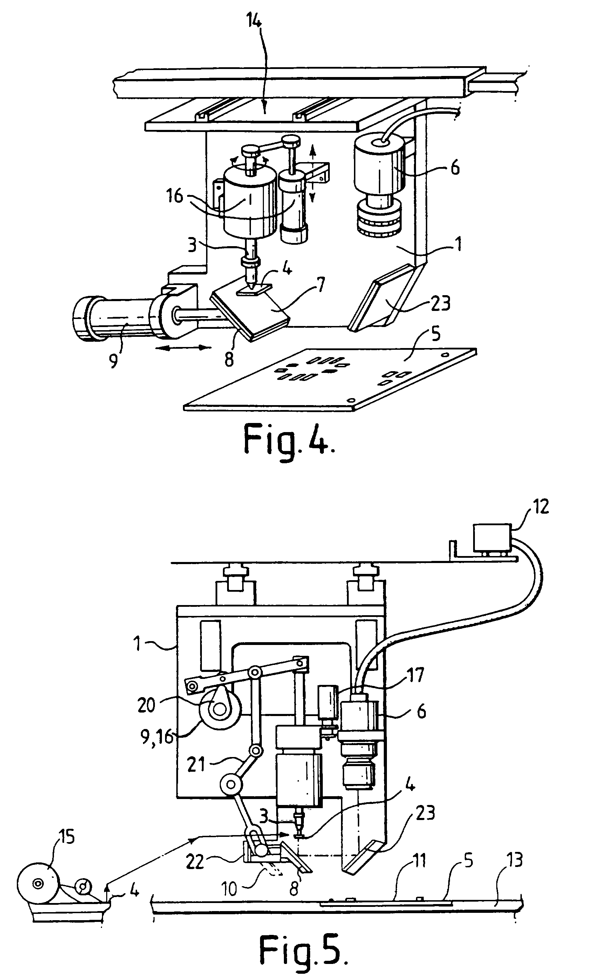

Fig. 4 shows a second embodiment of the present invention in which the mechanism for moving the optical component 8 and the mechanism for moving the nozzle 3 are separate. Apart from this, other components may be the same as in the first embodiment and will not be discussed in detail. In Fig. 4, it can be seen that the optical component 8 is mounted at the end of a piston rod of a piston 9, which moves the optical component parallel to the plane of the printed circuit board 5. This movement permits the optical component 8 to be moved from the position shown in Fig. 4, in which it contributed to defining an optical path between the component 4 on the nozzle 3 and the imaging apparatus (camera) 6 via the optical component 8 and the further reflection surface 23, and withdrawn position in which it is clear of the extension of the axis of the nozzle 3. The nozzle 3 is driven by a suitable driving device 16, which permits both vertical and rotational movement. The section embodiment has a relatively simple construction, but the timing of the movement due to driving device 9 and driving device 16 then needs to be synchronized.

Fig. 5 shows another embodiment of the present invention. which is substantially similar to the embodiment in Fig. 3, except that there has been some geometrical re-organization of the components. Fig. 5 also shows the store device 15 of the components 4.

In each of these embodiments, the head 1 moves immediately above an electronic component store device 15 and the nozzle 3 is lowered and vacuum adsorbs one electronic component 4 into the end of the nozzle 3. At this time, the optical component 8 having a reflection surface 7 is in a withdrawn position 10, e.g. to one side of the nozzle 3 where it does not impede the operation of the nozzle 3. The nozzle 3 rises and the head 1 moves linearly above the mounting target position 11 on the surface of the printed circuit board 5 and transfers the electronic component 4. During the transfer operation, the optical component 8 is positioned on the extension of the axis of the adsorption nozzle 3 and an image of the electronic component 4 can thus be seen by imaging apparatus 6.

The imaging apparatus 5 photographs the image of he electronic component 4 under instruction from the controller 12 of the imaging apparatus, determines whether the component 4 is correctly positioned on the nozzle 3 and measures the deviation [ΔX, ΔY, ΔΘ) of the position (X,Y) and the posture (Θ) of the electronic component 4 with respect to the head 1.

The optical component 8 is then again withdrawn to its withdrawn position 10 and the head stops at a suitable position, found by correcting the rotary angle round the axis of the nozzle 3 calculated on the basis of the image recognition result and adding the position correction distance in the X- and Y-directions calculated similarly to the original instruction position. Then, the nozzle 3 lowers, mounts the electronic component 4 onto the printed circuit board 5 and thus completes the mounting operation of one electronic component 4.

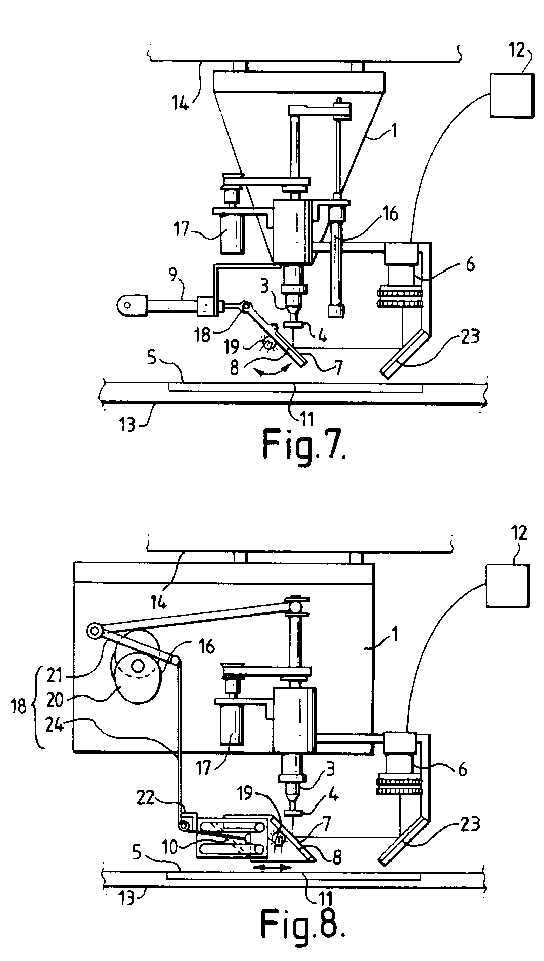

Next, a fourth embodiment of the present invention will be explained with reference to Fig. 6. In this embodiment, the driving device 16 for the vertical motion of the adsorption nozzle 3 and the driving device 9 for the motion of the optical component 8 are separate from each other and the controller 12 of the electronic component transporting apparatus generates the instructions to both driving devices 9 and 16 on the basis of a predetermined sequence so as to make the similar vertical motion and retreating motion. It is then similar to the second embodiment.

The second and fourth embodiments have the advantage that head 1 can be compact because a cam and a complicated transmission mechanism are not necessary.

Next, a fifth embodiment of the present invention will be explained with reference to Fig. 7. In this embodiment, the driving device 16 for the vertical motion of the adsorption nozzle 3 and the driving device 9 for the motion for the optical component 8 are again separate from each other. The operation of the driving device 9, for linear motion or rotation is converted to rotation through a transmission device 18, is transmitted to the optical component 8 and carries a retreating motion (withdrawal) of the reflection surface 7 relative to the axis of the nozzle 3.

This embodiment provides the advantage of accomplishing the withdrawal of the optical component 8 by a reciprocating motion or rotary motion of the driving device 9 with a short stroke. It is possible to combine the cam 20 of the first embodiment with the rotary withdrawal system of this embodiment.

Next, a sixth embodiment of the present invention will be explained with reference to Fig. 8.

This embodiment uses a steel belt 24 in place of the link mechanism used in the first embodiment. A link 21 is connected to the driving device 16 through the cam 20 separately from the cam and the link for moving the nozzle 3 vertically. The steel belt 24 is connected to the free end of the link 21 and the optical component 8 is connected to the other end of the steel belt 24 which is bent around a pulley fixed to the head 1.

In addition to the advantages obtained by the first embodiment, this embodiment provides the advantage that the transmission device 18 can be constructed compactly, using the cam 20, the link 21 and the steel belt 24.

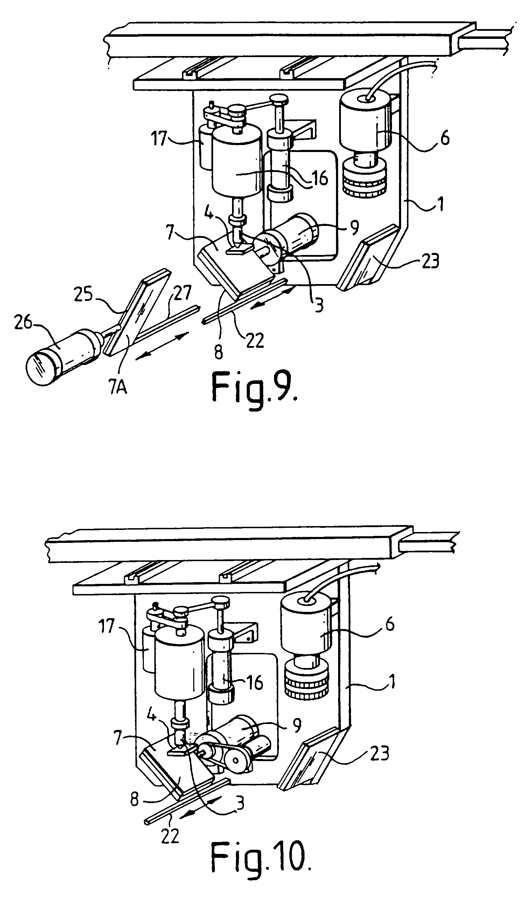

Next, a seventh embodiment of the present invention will be explained with reference to Fig. 9.

In this embodiment the nozzle 3 for adsorbing the electronic component 4, the driving device 16 for the vertical motion of the nozzle 3 and the driving device 17 for rotation of the nozzle 3 are provided on the head 1. Movable optical components 8 and 25 having respective reflection surfaces 7 and 7A, are mounted on the extension of the axis of the nozzle 3, and there is the driving device 9 for the motion of the optical component 8, a driving device 26 for the optical component 25, slide rails 22 and 27, the optical component 23 fixed to the head 1 and the imaging apparatus (camera) 6 fixed to the head 1.

An image of the electronic component 4 is generated at the imaging apparatus 6, there ten being an optical path between the component 4 and the imaging apparatus 6, via the further end indicated and optical components 8 and 23, on the extension of the axis of the nozzle 3. That image is generated during the transfer operation of the 2-axis Cartesian co-ordinate robot 14. Other types of robot, for example. Selective Assembly Robot Arm type robot or (SCARA type robot) or a cylindrical co-ordinate robot, can be employed in the present invention. Next, after the nozzle 3 is positioned immediately above the mounting target position 11, (see Fig. 3) the pattern being the mounting target position of the electronic component on the surface of the printed circuit board 5 or a mark existing at a predetermined position near the mounting target position is photographed with the optical component 25. The devices 9 and 26 are operated withdraw the optical component 8 and to move the optical component 25 so that it is aligned with the optical component 23, thus to define an optical path between the circuit board 5 and the engaging device 6.

Alternatively, the plurality of patterns or marks described above that are printed on the printed circuit board 5 may be photographed before the electronic component 4 is adsorbed.

In this embodiment, the direction of movement of the optical components 8 and 25 along by the slide rails 22 and 27 is perpendicular to the direction of the optical path to the imaging apparatus 6 in a horizontal plane. It is also possible to rotate the optical component 8 having one reflection surface as shown in Fig. 10 instead of having separate optical components 8 and 25.

In accordance with this embodiment, the image of the electronic component 4 can be obtained during the transfer operation, the head 1 need not stop once at a predetermined position for the purpose of photographing and only the optical component 8 having the reflection surface is withdrawn.

Therefore, this retreating motion can be made within a short period and the total time necessary for mounting the electronic component can be reduced. Furthermore, since the images of the patterns or marks around the periphery of the mounting target position 11 of the printed circuit board 5 can be obtained by the imaging apparatus 6 fixed to the head 1 which is stopped immediately above the mounting target position 11 either immediately before, or in advance of, the mounting of the electronic component, the relative displacement to be corrected between the head 1 and the target position 11 of the printed circuit board 5 can be determined directly. Accordingly, there is the advantage that the accuracy or otherwise of the suspension type robot 14 does not influence the photographing of the printed mounting board and the use of that photographed image to determine the movement of the nozzle 3 to achieve correct mounting of the component 4 unlike the known apparatus shown in Fig. 1 wherein the mounting head 1 is stopped at another position to photograph the electronic component or the apparatus of Japanese 63099/1986 wherein the optical axis of the imaging apparatus is brought into alignment with the mounting target position 11 in order to photograph the printed circuit board 5.

This embodiment provides a further advantage, namely that one imaging apparatus 6 can generate the image of the electronic component 4 as well as the images of the patterns or marks.

All the above embodiments related to the case where the apparatus for transporting a component had a single camera, which camera was mounted on the head.

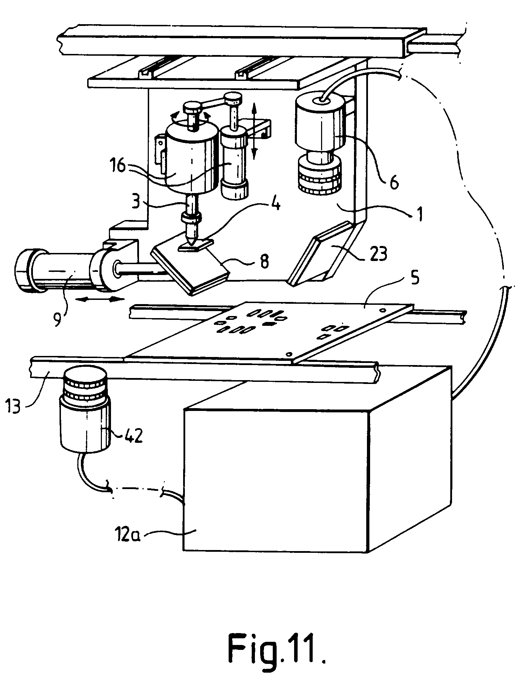

Next, an eighth embodiment of the present invention will be described, in which there are two cameras. The embodiment will be described with reference to Fig. 11. In Fig. 11, parts which are generally similar to corresponding parts of the earlier embodiments are indicated by the same reference numerals.

As can be seen from Fig. 11, a first imaging device (camera) 6 is mounted on the head 1. Indeed, the arrangement of the imaging device 6, the probe 3 which holds an electronic component 4, the optical components 8 and 23, and the drive mechanisms 9 and 16 are the same as in the embodiment of Fig. 4, and will not be discussed.

However, unlike the previous embodiments, there is a second imaging device (camera) 42 which is positioned next to the conveyor 13 which supports the printed circuit board 5. Indeed, this imaging device 42 may be the same as the conventional camera 2 shown in Fig. 1. However, as can be seen from Fig. 11, the two imaging apparatus 6 and 42 are connected to a common controller 12A, which enables either or both of these imaging apparatuses 6, 42 to observe to a electronic component 4. Preferably, the first imaging apparatus 6 has a narrow field of view, and the second imaging apparatus 42 has a wide field of view. Then, if a small electronic component 4 is picked up by the nozzle 3, a detailed picture of it may be obtained using the imaging apparatus 6, which views the electronic component 4 via the optical components 8 and 23.

If, on the other hand, the electronic component 4 is large, then the field of view of the imaging apparatus 6 may be too narrow to observe the whole of that electronic component. In such a case, the head 1 may be moved so that the electronic component 4 is above the second imaging apparatus 42, the optical component 8 withdrawn using the driving device 9, and the electronic component 4 may then be observed by the second imaging apparatus 42. The detection of the position of such a large component, relative to the head 1 is then the same as in the known systems with reference to Fig. 1. However, with the embodiment of Fig. 11, there is the advantage that a more precise measurement of the position of a smaller electronic component can be obtained then is possible in the prior art, because the first imaging apparatus 6 may be used for such a small component.

The use of imaging apparatuses 6, 42 with different fields of view may be used in conjunction with the provision of stores for different sizes components. This can be seen referring to Fig. 1, in which the store 15 is for small components and the store 15a is for large electronic components. If the second imaging apparatus 42 is located proximate the store 15a for the large electronic components, in the same way that the imaging apparatus 2 is located near the store 15a in Fig. 1, then the head 1 needs to move a large electronic component only by a short distance before it can be observed by the second imaging apparatus 42.

Where electronic components are stored in different stores depending on the size of the electronic component, then the controller 12a may co-ordinate the detection of the position of each component relative to the head 1 in dependance on the store 15, 15a from which that electronic component 4 has been picked up by the nozzle 3 of the head 1.

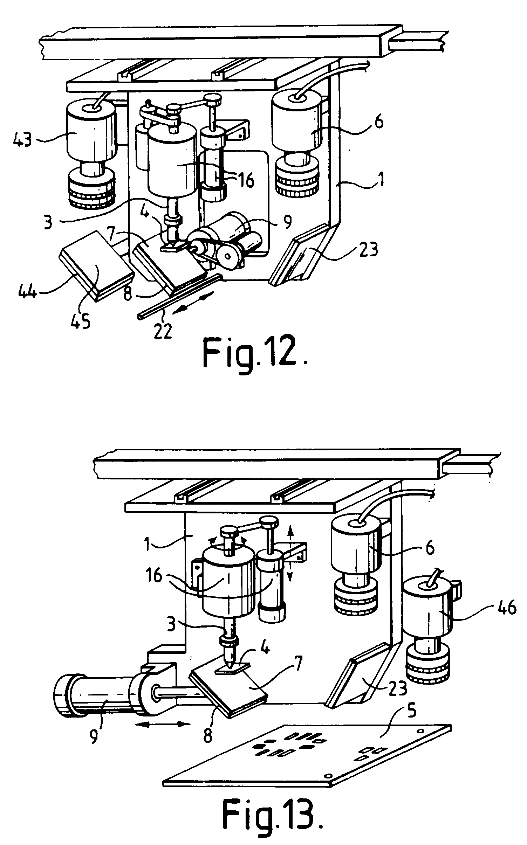

In the eighth embodiment, described with reference to Fig. 11, the imaging apparatus (camera) 6 with a narrow field of view is mounted on the head 1, and the imaging apparatus 42 with a wide field of view is mounted on the base 100. However, it is also possible for both imaging apparatuses to be mounted on the head, as shown in the ninth embodiment, illustrated in Fig. 12. In Fig. 12, parts which correspond to parts of embodiments described earlier are indicated by the same reference numerals.

In Fig. 12, there is a second imaging apparatus 43 which is mounted on the head. A third optical component 44 is then mounted below that imaging apparatus 43, which optical component 44 has a reflection surface 45 which directs the direction of view of the imaging apparatus 43 towards the electronic component 4. In the embodiment of Fig. 12, the optical component 8 is rotatable about an axis in its plane, as well as movable linearly parallel to that axis.

In the embodiment of Fig. 12, if the electronic component 4 is small, the detection of its position is as in the previous embodiments. Thus, the imaging apparatus 6 detects the location of the electronic component 4 on the nozzle 3, via the optical components 8 and 23. If, however, the electronic component 4 is too large to be observed by the imaging apparatus 6 (assuming that imaging apparatus has a narrow field of view), then the optical component 8 is rotated about an axis in its plane, so that it turns through substantially 90° in an anti-clockwise direction Fig. 12. When the optical component 8 is in that position, the second imaging apparatus 43 may observe the position of the component 4 on the nozzle 3 via the third optical component 44 and the first optical component 8. If the second imaging apparatus 43 has a wide field of view, large components may then be observed. When the position of the electronic component 4 on the nozzle 3 has been observed by either the first or second imaging apparatuses 6, 43, then the optical component 8 may be moved linearly in its plane, along rail 22, so that it is clear of the axis of the nozzle 3, so that the electronic component 4 may be lowered onto a printed circuit board 5.

This ninth embodiment gives the same advantage as the eighth embodiment, namely that the position of different sized electronic components may be measured accurately, but it also has the advantage that, since the second imaging apparatus 43 is mounted on the head 1, there is less risk of a poor image due to image shake, and also there is no delay whilst the head 1 moves to the position of the second imaging apparatus 42, as in the eighth embodiment.

In the eighth and ninth embodiments, described with reference to Figs. 11 and 12, a second imaging apparatus (camera) is provided for observing large electronic components. In the tenth embodiment of the present invention, shown in Fig. 13, a second imaging apparatus (camera) is provided but in this case the second imaging apparatus is for observing the printed circuit board.

In Fig. 13, components which are similar to components of earlier embodiments are indicated by the same reference numerals. Thus, it can be seen that the arrangement of the first imaging apparatus (camera) 6 mounted on the head 1 is the same as in the embodiment shown in Fig. 4.

However, Fig. 13 also shows a second imaging apparatus (camera) 44 which is mounted on the head 1 and is directed downwardly so that it may observe the printed circuit board 5. Thus, this camera may observe the exact position of the head 1 relative to the printed circuit board 5, to increase the precision of positioning of the electronic component 4 on the printed circuit board 5 when the electronic component 4 is lowered onto the printed circuit board 5. Thus, this embodiment is related to the seventh embodiment of the invention, described with reference to Fig. 9, and in a similar way patterns or marks may be provided on the printed circuit board 5, to assist in the determination of the position of the head 1 above a suitable target position.

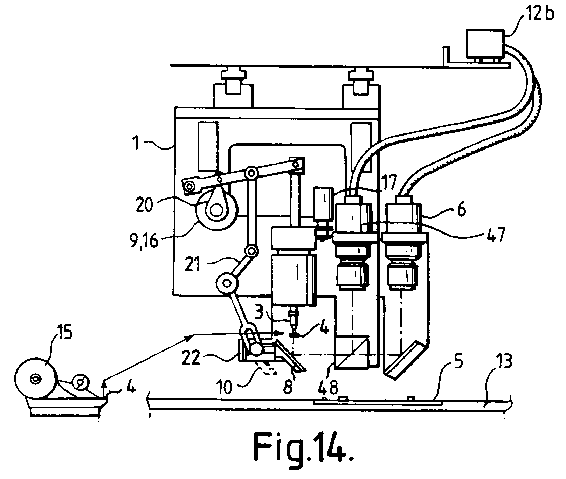

An arrangement which combines the advantages of the ninth and tenth embodiments is shown in Fig. 14. Parts of this embodiment which are similar to parts of the embodiment of Fig. 5 are indicated by the same reference numerals, and will not be described in detail. However, Fig. 14 shows a second imaging apparatus 47, and a beam splitter 48. Thus, the second imaging apparatus (camera) 47 may observe the electronic component 4 via the beam splitter 48 and the first optical component 8, whilst the first imaging apparatus (camera) 6 can observe the electronic component 4 via the optical component 23, the beam splitter 48, and the first optical component 8. Thus, the controller 12B may select the appropriate imaging apparatus 6, 47 in dependence on the size of the electronic component 4 without there being any physical movement of the optical components 8, 23 or beam splitter 48, since the beam splitter 48 permits an image of the electronic component 4 to be generated simultaneously at the first and second imaging apparatuses 6, 47. Therefore, this embodiment has the advantage that , independent of the size of the electronic component 4, its position relative to the nozzle 3 may be determined rapidly because the controller 12a will select only the appropriate signals from the first and second imaging apparatuses 6, 47 for further processing.

By suitable design of the beam splitter 48, either the first or second imaging apparatus 6, 48 may be used to observe the printed circuit board 5. The beam splitter 48 may permit light to pass directly from the board 5 to the second imaging apparatus 47, or may direct light from the board 5 to the optical component 23, and then to the first imaging apparatus 6. Again, no physical movement of the optical components 8, 23, the beam splitter 48, or the imaging apparatuses 6, 47 is necessary to achieve this.

Thus, in accordance with the present invention, transfer of the electronic component and detection of displacement (position) of an electronic component can be executed simultaneously. Accordingly, the head need not stop at a predetermined position for the purpose of photographing the electronic component (except possibly if that component is large) and the electronic component can be transferred through the shortest path. The optical components are lighter in weight and need a shorter alignment time for positioning, as compared with the known technique which moves the optical system as a whole inclusive of the imaging apparatus 6 and the like and for this reason, the retreating operation can be made at a higher speed. Thus, a shortening of the total time for mounting the electronic component can be obtained.

Since the imaging apparatus (camera) fixed to the head measures directly the displacement of the electronic component with respect to the nozzle, the position error of the head at the time of photographing does not affect the measurement result and accuracy of the mounting position can be improved.

## Claims

1. An apparatus for transporting a component (4), comprising:
a base (100);
holding means (3) for holding said component (4);
a head (1) supporting the holding means (3), the head (1) being connected and movable relative to said base in a first direction, thereby to cause transportation of said component (4) relative to said base (100) when said component (4) is held by said holding means (3);
an imaging apparatus (6) on said head (1) for investigating said component (4) optically when said component (4) is held on said holding means (3); and
one or plurality of optical components (8) on said head (1) for defining an optical path between said imaging apparatus (6) and said component when said component (4) is held by said holding means (3);
characterised in that:
said imaging apparatus (6) is fixed to said head (1), and said one or only one of said plurality of optical components (8) is movable relative to said imaging apparatus (6) between an operating position, in which said optical path is defined between said imaging apparatus (6) and said component (4) when said component is held by said holding means (3), and a withdrawn position in which said one or only one of said plurality of optical components (8) does not interfere with processing of said component (4).

2. An apparatus according to claim 1, wherein said optical component (8) is movable linearly in a plane substantially perpendicular to said first direction.

3. An apparatus according to claim 1 or claim 2, wherein said one or only one of said plurality of optical components (8) is movable in a direction substantially parallel to the direction of incidence on said one or only one of said plurality of optical components (8) of the part of said optical path from said imaging apparatus (6) to said one or only one of said plurality of optical components (8).

4. An apparatus according to any one of claims 1 to 3, wherein said one or only one of said plurality of optical components (8) is movable in a direction substantially perpendicular to the direction of incidence on said at least one optical component (8) of the part of said optical path from said imaging apparatus (6) to said one or only one of said plurality of optical components (8).

5. An apparatus according to claim 1, wherein said one or only one of said plurality of optical components (8) is rotatable between said operating position and said withdrawn position.

6. An apparatus according to any one of the preceding claims, further including a further imaging apparatus (42) fixed to said base (100) for investigating said component (4) when said component (4) is held on holding means (3) in a predetermined position relative to said base (100).

7. An apparatus according to any one of claims 1 to 5, further including a further imaging apparatus (42) fixed to said head (1) when said component (4) is held on a holding means (3) in a predetermined position relative to said base (100).

8. An apparatus according to claim 7, wherein said head (1) is movable relative to said base (100) such as to move said holding means (3) from a position in which said component (4) is in said predetermined position to an additional position.

9. An apparatus according to claim 7 or claim 8, wherein said one or only one of said plurality of optical components (8) has an additional position in which an additional optical path is defined between said further imaging apparatus (43) and said component (4) when said component is held by said holding means (1).

10. An apparatus according to any one of claims 7 to 9, having a further optical component (44) for defining a further optical path including said further component (44) between said further imaging apparatus (43) and said component (4) when said component (4) is held by said holding means (1).

11. An apparatus according to any one of the preceding claims, wherein said imaging apparatus (6) has a narrow angle of view, and said apparatus includes a further imaging apparatus (42,43,46) having a wide angle of view for investigating said component when said component is held by said holding means.

12. An apparatus according to any one of the preceding claims, wherein said holding means (3) is a nozzle.

13. An apparatus according to any one of the preceding claims, wherein said first direction intersects said one or only one of said plurality of optical components (8) when said optical component (8) is in said operating position.

14. An apparatus according to any one of the preceding claims, further including a linkage (18) between said one or only one of said plurality of optical components (8) and said holding means (3) for moving said one or only one of said plurality of optical components and said holding means simultaneously.

15. An apparatus according to any one of the preceding claims, wherein said base (100) has means (13) for supporting a board (5) thereon in a selected position.

16. An apparatus according to claim 15 wherein said one or only one of said plurality of optical components (8) is rotatable from said operating position to a board-viewing position, in which board-viewing position an additional optical path is defined between said imaging apparatus (6) and said selected position via said one or only one of said plurality of optical components (8).

17. An apparatus according to any one of the preceding claims, wherein said head (1) is connected to said base (100) via a two-axis orthogonal robot (14).

18. An apparatus according to any one of the preceding claims wherein said imaging apparatus (6) is a camera.

19. An apparatus according to any one of the preceding claims, further including a controller (12, 12a, 12b) for controlling movement of at least said head (1) and said one or only one of said plurality of optical components (8).

20. An apparatus according to any one of the preceding claims, further including storage means (15,15a) on said base (100) for storing a plurality of electrical components, any of said electrical component corresponding to said components to be transported by said apparatus.

21. A method of transporting a component (4) using a transportation apparatus comprising a base, a head movable connected to said base, (1), holding means (3) on said head (1), an imaging apparatus (6) fixed to said head (1), and at least one optical component on said head (1), the method comprising:
holding said component (4) on said holding means (3); and
moving said head (1) relative to said base (100) when said component (4) is held by said holding means (3), thereby to transport said component (4);
characterised in that:
the imaging apparatus (6) is fixed to the head (1); and
said method further includes:
moving said optical component (8) relative to said imaging apparatus (6) from a withdrawn position to an operating position, in which operating position an optical path is defined between said imaging apparatus (6) and said component (4);
investigating said component (4) optically using said imaging apparatus (6); and
moving said optical component (8) to said withdrawn position in which said optical component (8) does not interfere with processing of said component (4).

22. A method according to claim 21, wherein the apparatus further includes a further imaging apparatus (42,44,45) having a wide angle of view; and
the method includes:
determining whether said component (4) is greater than a predetermined size;
wherein:
when said component (4) is less than said predetermined size, said method further includes investigating said component (4) using said imaging apparatus (6); and wherein:
when said component (4) is greater than said predetermined size, said method further includes investigating said component (4) using said further imaging apparatus (42,44,45).

23. A method according to claim 21, wherein the apparatus includes a further imaging apparatus (42) fixed to said base (100); and
the method further includes:
determining whether said component is greater than a predetermined size;
wherein:
when said component (4) is less than said predetermined size, said method further includes investigating said component (4) using said imaging apparatus (6); and wherein:
when said component (4) is greater than said predetermined size, said method further includes investigating said component (4) using said further imaging apparatus (42).

24. A method according to any one of claims 21 to 23, wherein said component (4) is held in a component store (15,15a) on said base (100) prior to being held by said holding means (3).

25. A method according to any one of claims 21 to 24, wherein said base (3) supports a board (5), and said component (4) is transported to said board (5) subsequent to the investigation of said component by said imaging apparatus (6).

26. A method according to claim 25, wherein said at least one optical component (8) is moved to a further position in which an optical path is defined between said imaging apparatus (6) and said board (5) via said at least one optical component (8), during the transportation of said component (4) to said board (5).

## Patentansprüche

1. Vorrichtung zum Transport eines Bauteils (4) mit:
- einem Träger (100);
- einer Halteeinrichtung (3) zum Halten des Bauteils (4);
- einem die Halteeinrichtung (3) tragenden Kopf (1), der mit dem Träger verbunden ist und relativ zu diesem in einer ersten Richtung verstellbar ist, um dadurch einen Transport des Bauteils (4) relativ zum Träger (100) hervorzurufen, wenn das Bauteil (4) durch die Halteeinrichtung (3) gehalten wird;
- einer Bilderzeugungseinrichtung (6) am Kopf (1) zum optischen Untersuchen des Bauteils (4), wenn es an der Halteeinrichtung (3) gehalten wird; und
- einer optischen Komponente (8) oder mehrere am Kopf (1) zum Festlegen eines optischen Pfads zwischen der Bilderzeugungsvorrichtung (6) und dem Bauteil, wenn dieses Bauteil (4) durch die Halteeinrichtung (3) gehalten wird;
**dadurch gekennzeichnet**, daß
- die Bilderzeugungsvorrichtung (6) am Kopf (1) befestigt ist und die eine optische'Komponente (8) oder nur eine derselben zwischen einer Betriebsposition, in der der optische Pfad zwischen der Bilderzeugungsvorrichtung (6) und dem Bauteil (4) festgelegt ist, wenn das Bauteil von der Halteeinrichtung (3) gehalten wird, und einer zurückgezogenen Position, in der die eine optische Komponente (8) oder nur eine der mehreren derselben die Bearbeitung des Bauteils (4) nicht stört, relativ zur Bilderzeugungsvorrichtung (6) verstellbar ist.

2. Vorrichtung nach Anspruch 1, bei der die optische Komponente (8) in einer Ebene im wesentlichen rechtwinklig zur ersten Richtung linear verstellbar ist.

3. Vorrichtung nach Anspruch 1 oder Anspruch 2, bei der die eine optische Komponente (8) oder nur eine der mehreren derselben in einer Richtung im wesentlichen parallel zur Richtung des Strahlungseinfalls auf die eine optische Komponente (8) oder nur eine der mehreren derselben in demjenigen Teil des optischen Pfads von der Bilderzeugungsvorrichtung (6) zur einen optischen Komponente (8) oder nur einer der mehreren derselben verstellbar ist.

4. Vorrichtung nach einem der Ansprüche 1 bis 3, bei der die eine optische Komponente (8) oder nur eine der mehreren derselben in einer Richtung im wesentlichen rechtwinklig zur Richtung des Strahlungseinfalls auf die mindestens eine optische Komponente (8) des Teils des optischen Pfads von der Bilderzeugungsvorrichtung (6) zur einen optischen Komponente (8) oder nur einer der mehreren derselben verstellbar ist.

5. Vorrichtung nach Anspruch 1, bei der die eine optische Komponente (8) oder nur eine der mehreren derselben zwischen der Betriebsposition und der zurückgezogenen Position verdrehbar ist.

6. Vorrichtung nach einem der vorstehenden Ansprüche, ferner mit einer weiteren Bilderzeugungsvorrichtung (42), die am Träger (100) angebracht ist, um das Bauteil (4) zu untersuchen, wenn es in einer vorgegebenen Position relativ zum Träger (100) an der Halteeinrichtung (3) gehalten wird.

7. Vorrichtung nach einem der Ansprüche 1 bis 5, ferner mit einer weiteren Bilderzeugungsvorrichtung (42), die am Kopf (1) befestigt ist, wenn das Bauteil (4) an einer vorgegebenen Position relativ zum Träger (100) an einer Halteeinrichtung (3) gehalten wird.

8. Vorrichtung nach Anspruch 7, bei der der Kopf (1) in solcher Weise relativ zum Träger (100) verstellbar ist, daß die Halteeinrichtung (3) von einer Position, in der sich das Bauteil (4) an der vorgegebenen Position befindet, in eine zusätzliche Position zu verstellen.

9. Vorrichtung nach Anspruch 7 oder Anspruch 8, bei der die eine optische Komponente (8) oder nur eine der mehreren derselben eine zusätzliche Position aufweist, bei der ein zusätzlicher optischer Pfad zwischen der weiteren Bilderzeugungsvorrichtung (43) und dem Bauteil (4) festgelegt ist, wenn dieses Bauteil durch die Halteeinrichtung (3) gehalten wird.

10. Vorrichtung nach einem der Ansprüche 7 bis 9, mit einer weiteren optischen Komponente (44) zum Festlegen eines weiteren optischen Pfads, der diese weitere Komponente (44) enthält, zwischen der weiteren Bilderzeugungsvorrichtung (43) und dem Bauteil (4), wenn dieses Bauteil (4) von der Halteeinrichtung (1) gehalten wird.

11. Vorrichtung nach einem der vorstehenden Ansprüche, bei der die Bilderzeugungsvorrichtung (6) einen engen Gesichtswinkel aufweist und die Vorrichtung ferner eine weitere Bilderzeugungsvorrichtung (42, 43, 46) mit einem weiten Gesichtswinkel aufweist, um das Bauteil zu untersuchen, wenn dieses Bauteil von der Halteeinrichtung gehalten wird.

12. Vorrichtung nach einem der vorstehenden Ansprüche, bei der die Halteeinrichtung (3) eine Düse ist.

13. Vorrichtung nach einem der vorstehenden Ansprüche, bei der die erste Richtung die eine optische Komponente (8) oder nur eine der mehreren derselben schneidet, wenn sich die optische Komponente (8) in der Betriebsposition befindet.

14. Vorrichtung nach einem der vorstehenden Ansprüche, ferner mit einer Verbindung (18) zwischen der einen optischen Komponente (8) oder nur einer der mehreren derselben und der Halteeinrichtung (3) zum gleichzeitigen Verstellen der einen optischen Komponente oder nur einer der mehreren derselben und der Halteeinrichtung.

15. Vorrichtung nach einem der vorstehenden Ansprüche, bei der der Träger (100) über eine Einrichtung (13) zum Halten einer Platte (5) in einer ausgewählten Position verfügt.

16. Vorrichtung nach Anspruch 15, bei der die eine optische Komponente (8) oder nur eine der mehreren derselben aus der Betriebsposition in eine Plattenbetrachtungsposition verdrehbar ist, wobei in der Plattenbetrachtungsposition ein zusätzlicher optischer Pfad zwischen der Bilderzeugungsvorrichtung (6) und der ausgewählten Position über die eine optische Komponente (8) oder nur eine der mehreren derselben festgelegt ist.

17. Vorrichtung nach einem der vorstehenden Ansprüche, bei der der Kopf (1) über einen Roboter (14) mit zwei zueinander rechtwinkligen Achsen mit dem Träger (100) verbunden ist.

18. Vorrichtung nach einem der vorstehenden Ansprüche, bei der die Bilderzeugungsvorrichtung (6) eine Kamera ist.

19. Vorrichtung nach einem der vorstehenden Ansprüche, ferner mit einer Steuerung (12, 12a, 12b) zum Steuern der Verstellung mindestens des Kopfs (1) und der einen optischen Komponente (8) oder nur einer der mehreren derselben.

20. Vorrichtung nach einem der vorstehenden Ansprüche, ferner mit einer Magazineinrichtung (15, 15a) auf dem Träger (100) zum Aufnehmen mehrerer elektrischer Bauteile, wobei jedes elektrische Bauteil den von der Vorrichtung zu transportierenden Bauteilen entspricht.

21. Verfahren zum Transportieren eines Bauteils (4) unter Verwendung einer Transportvorrichtung mit einem Träger, einem Kopf (1), der verstellbar mit dem Träger verbunden ist, einer Halteeinrichtung (3) am Kopf (1), einer am Kopf (1) befestigten Bilderzeugungsvorrichtung (6) und mindestens einer optischen Komponente am Kopf (1), wobei das Verfahren folgendes umfaßt:
- Halten des Bauteils (4) an der Halteeinrichtung (3); und
- Verstellen des Kopfs (1) relativ zum Träger (100), wenn das Bauteil (4) durch die Halteeinrichtung (3) gehalten wird, um dadurch dieses Bauteil (4) zu transportieren; **dadurch gekennzeichnet**, daß die Bilderzeugungsvorrichtung (6) am Kopf (1) befestigt ist und das Verfahren ferner folgendes umfaßt:
- Verstellen der optischen Komponente (8) ausgehend von einer zurückgezogenen Position in eine Betriebsposition relativ zur Bilderzeugungsvorrichtung (6), wobei in der Betriebsposition ein optischer Pfad zwischen der Bilderzeugungsvorrichtung (6) und dem Bauteil (4) festgelegt ist;
- optisches Untersuchen des Bauteils (4) unter Verwendung der Bilderzeugungsvorrichtung (6); und
- Verstellen der optischen Komponente (8) in die zurückgezogene Position, in der diese optische Komponente (8) eine Bearbeitung des Bauteils (4) nicht stört.

22. Verfahren nach Anspruch 21, bei dem die Vorrichtung ferner eine weitere Bilderzeugungsvorrichtung (42, 44, 45) mit einem großen Gesichtswinkel aufweist und das Verfahren folgendes umfaßt:
- Ermitteln, ob das Bauteil (4) größer als eine vorgegebene Größe ist;
- wobei dann, wenn das Bauteil (4) kleiner als die vorgegebene Größe ist, das Verfahren den weiteren Schritt einer Untersuchung des Bauteils (4) unter Verwendung der Bilderzeugungsvorrichtung (6) umfaßt; und
- wobei dann, wenn das Bauteil (4) größer als die vorgegebene Größe ist, das Verfahren ferner eine Untersuchung des Bauteils (4) unter Verwendung der weiteren Bilderzeugungsvorrichtung (42, 44, 45) beinhaltet.

23. Verfahren nach Anspruch 21, bei dem die Vorrichtung eine weitere, am Träger (100) befestigte Bilderzeugungsvorrichtung (42) aufweist und das Verfahren ferner folgendes umfaßt:
- Ermitteln, ob das Bauteil größer als eine vorgegebene Größe ist;
- wobei dann, wenn das Bauteil (4) kleiner als die vorgegebene Größe ist, das Verfahren ferner ein Untersuchen des Bauteils (4) unter Verwendung der Bilderzeugungsvorrichtung (6) umfaßt; und
- wobei dann, wenn das Bauteil (4) größer als die vorgegebene Größe ist, das Verfahren ferner eine Untersuchung des Bauteils (4) unter Verwendung der weiteren Bilderzeugungsvorrichtung (42) umfaßt.

24. Verfahren nach einem der Ansprüche 21 bis 23, bei dem das Bauteil (4) in einem Bauteilemagazin (15, 15a) auf dem Träger (100) aufbewahrt wird, bevor es von der Halteeinrichtung (3) gehalten wird.

25. Verfahren nach einem der Ansprüche 21 bis 24, bei dem der Träger (3) eine Platte (5) hält und das Bauteil (4) anschließend an die Untersuchung desselben durch die Bilderzeugungsvorrichtung (6) zu dieser Platte (5) transportiert wird.

26. Verfahren nach Anspruch 25, bei dem die mindestens eine optische Komponente (8) in eine weitere Position verstellt wird, in der während des Transports des Bauteils (4) zur Platte (5) ein optischer Pfad über die mindestens eine optische Komponente (8) zwischen der Bilderzeugungsvorrichtung (6) und der Platte (5) festgelegt ist.

## Revendications

1. Dispositif pour transporter un composant (4), comportant :
une base (100);
des moyens de retenue (3) pour retenir ledit composant (4);
une tête (1) supportant les moyens de retenue (3), la tête (1) étant connectée à et déplaçable par rapport à ladite base dans une première direction, de manière à provoquer un transport dudit composant (4) par rapport à ladite base (100) lorsque ledit composant (4) est retenu par lesdits moyens de retenue (3);
un dispositif de formation d'images (6) situé sur ladite tête (1) pour examiner optiquement ledit composant (4) lorsque ledit composant (4) est retenu sur lesdits moyens de retenue (3); et
un ou une pluralité de composants optiques (8) situés sur ladite tête (1) pour définir un trajet optique entre ledit dispositif de formation d'images (6) et ledit composant lorsque ledit composant (4) est retenu par lesdits moyens de retenue (3);
caractérisé en ce que :
ledit dispositif de formation d'images (6) est fixé à ladite tête (1), et ledit composant optique ou l'un seulement de ladite pluralité de composants optiques (8) est déplaçable par rapport audit dispositif de formation d'images (6) entre une position de fonctionnement, dans laquelle ledit trajet optique est défini entre ledit dispositif de formation d'images (6) et ledit composant (4), lorsque ledit composant est retenu par lesdits moyens de retenue (3), et une position rétractée, dans laquelle ledit composant optique ou l'un seulement de ladite pluralité de composants optiques (8) n'interfère pas avec le traitement dudit composant (4).

2. Dispositif selon la revendication 1, dans lequel ledit composant optique (8) est déplaçable linéairement dans un plan sensiblement perpendiculaire à ladite première direction.

3. Dispositif selon la revendication 1 ou 2, dans lequel ledit composant optique ou l'un seulement de ladite pluralité de composants optiques (8) est déplaçable dans une direction sensiblement parallèle à la direction d'incidence, sur ledit composant optique ou sur l'un seulement de ladite pluralité de composants optiques (8), de la partie dudit trajet optique partant dudit dispositif de formation d'images (6) en direction dudit composant optique ou de l'un seulement de ladite pluralité de composants optiques (8).

4. Dispositif selon l'une quelconque des revendications 1 à 3, dans lequel ledit composant optique ou l'un seulement de ladite pluralité de composants optiques (8) est déplaçable dans une direction sensiblement perpendiculaire à la direction d'incidence, sur ledit au moins un composant optique (8), de la partie dudit trajet optique partant dudit dispositif de formation d'images (6) en direction dudit composant optique ou de l'un seulement de ladite pluralité de composants optiques (8).

5. Dispositif selon la revendication 1, dans lequel ledit composant optique ou l'un seulement de ladite pluralité de composants optiques (8) peut tourner entre ladite position de fonctionnement et ladite position rétractée.

6. Dispositif selon l'une quelconque des revendications précédentes, comportant en outre un autre dispositif de formation d'images (42) fixé à ladite base (100) pour examiner ledit composant (4) lorsque ledit composant (4) est retenu sur des moyens de retenue (3) dans une position prédéterminée par rapport à ladite base (100).

7. Dispositif selon l'une quelconque des revendications 1 à 5, comportant en outre un autre dispositif de formation d'images (42) fixé à ladite tête (1) lorsque ledit composant (4) est retenu sur des moyens de retenue (3) dans une position prédéterminée par rapport à ladite base (100).

8. Dispositif selon la revendication 7, dans lequel ladite tête (1) est déplaçable par rapport à ladite base (100) de manière à déplacer lesdits moyens de retenue (3) depuis une position, dans laquelle ledit composant (4) est dans ladite position prédéterminée,j usque dans une position supplémentaire.

9. Dispositif selon la revendication 7 ou 8, dans lequel ledit composant optique ou l'un seulement de ladite pluralité de composants optiques (8) possède une position supplémentaire, dans laquelle un trajet optique supplémentaire est défini entre ledit autre dispositif de formation d'images (43) et ledit composant (4) lorsque ledit composant est retenu par lesdits moyens de retenue (1).

10. Dispositif selon l'une quelconque des revendications 7 à 9, comportant un autre composant optique (44) pour définir un autre trajet optique comprenant ledit autre composant (44) entre ledit autre dispositif de formation d'images (43) et ledit composant (4), lorsque ledit composant (4) est retenu par lesdits moyens de retenue (1).

11. Dispositif selon l'une quelconque des revendications précédentes, dans lequel ledit dispositif de formation d'images (6) possède un angle d'observation étroit, et ledit dispositif comporte un autre dispositif de formation d'images (42,43,46) possédant un angle étendu d'observation pour examiner ledit composant lorsque ledit composant est retenu par lesdits moyens de retenue.

12. Dispositif selon l'une quelconque des revendications précédentes, dans lequel lesdits moyens de retenue (3) sont une buse.

13. Dispositif selon l'une quelconque des revendications précédentes, dans lequel ladite première direction recoupe ledit composant optique ou l'un seulement de ladite pluralité de composants optiques (8) lorsque ledit composant optique (8) est dans ladite position de fonctionnement.

14. Dispositif selon l'une quelconque des revendications précédentes, comprenant en outre un système de liaison (18) entre ledit composant optique ou l'un seulement de ladite pluralité de composants optiques (8) et lesdits moyens de retenue (3) pour déplacer simultanément ledit composant optique ou l'un seulement de ladite pluralité de composants optiques et lesdits moyens de retenue.

15. Dispositif selon l'une quelconque des revendications précédentes, dans lequel ladite base (100) comporte des moyens (13) pour supporter un panneau (5) dans une position sélectionnée.

16. Dispositif selon l'une quelconque des revendications 15, dans lequel ledit composant optique ou l'un seulement de ladite pluralité de composants optiques (8) peut tourner depuis ladite position de fonctionnement jusque dans une position d'observation du panneau, dans laquelle un trajet optique supplémentaire est défini entre le dispositif de formation d'images (6) et ladite position sélectionnée par l'intermédiaire dudit composant optique ou de l'un seulement de ladite pluralité de composants optiques (8).

17. Dispositif selon l'une quelconque des revendications précédentes, dans lequel ladite tête (1) est raccordée à ladite base (100) par l'intermédiaire d'un robot orthogonal à deux axes (14).

18. Dispositif selon l'une quelconque des revendications précédentes, dans lequel ledit dispositif de formation d'images (6) est un appareil de prise de vues.

19. Dispositif selon l'une quelconque des revendications précédentes, comprenant en outre un dispositif de commande (12,12a,12b) pour commander le déplacement au moins de ladite tête (1) et dudit composant optique ou de l'un seulement de ladite pluralité de composants optiques (8).

20. Dispositif selon l'une quelconque des revendications précédentes, comportant en outre des moyens de stockage (15, 15a) situés sur ladite base (100) pour stocker une pluralité de composants électriques, l'un quelconque desdits composants optiques correspondant auxdits composants devant être transportés par ledit dispositif.

21. Procédé de transport de composants (4) utilisant un dispositif de transport comprenant une base, une tête déplaçable (1) raccordée à ladite base, des moyens de retenue (3) situés sur ladite tête (1), un dispositif de formation d'images (6) fixé à ladite tête (1) et au moins un composant optique sur ladite tête (1), le procédé comprenant les étapes consistant à :
retenir ledit composant (4) sur lesdits moyens de retenue (3); et
déplacer ladite tête (1) par rapport à ladite base (100) lorsque ledit composant (5) est retenu par lesdits moyens de retenue (3), de manière à transporter ledit composant (4);
caractérisé en ce que :
le dispositif de formation d'images (6) est fixé à la tête (1); et
ledit procédé comprend en outre les étapes consistant à :
déplacer ledit composant optique (8) par rapport audit dispositif de formation d'images (6) depuis une position rétractée jusque dans une position de fonctionnement, dans laquelle un trajet optique est défini entre ledit dispositif de formation d'images (6) et ledit composant (4);
examiner optiquement ledit composant (4) en utilisant ledit dispositif de formation d'images (6); et
déplacer ledit composant optique (8) jusque dans ladite position rétractée, dans laquelle ledit composant optique (8) n'interfère pas avec le traitement dudit composant (4).

22. Procédé selon la revendication 21, dans lequel le dispositif comporte en outre un autre dispositif de formation d'images (42,44,45) possédant un grand angle d'observation; et
le procédé comprend :
la détermination du moment où ledit composant (4) est supérieur à une taille prédéterminée;
auquel cas :
lorsque ledit composant (4) est inférieur à ladite taillé prédéterminée, ledit procédé comprend en outre l'examen dudit composant (4) moyennant l'utilisation dudit dispositif de formation d'images (6); et :
lorsque ledit composant (4) est supérieur à ladite taille prédéterminée, ledit procédé inclut en outre l'examen dudit composant (4) en utilisant ledit autre dispositif de formation d'images (42,44,45).

23. Procédé selon la revendication 1, dans lequel le dispositif comporte un autre dispositif de formation d'images (42) fixé à ladite base (100); et
le procédé comprend en outre :
la détermination du fait que le composant est supérieur ou non à une taille prédéterminée;
auquel cas :
lorsque ledit composant (4) est inférieur à ladite taille prédéterminée, ledit procédé comprend en outre l'examen dudit composant (4) en utilisant ledit dispositif de formation d'images (6); et :
lorsque ledit composant (4) est supérieur à ladite taille prédéterminée, ledit procédé comprend en outre l'examen dudit composant (4) en utilisant ledit autre dispositif de formation d'images (42).

24. Procédé selon l'une quelconque des revendications 21 à 23, dans lequel ledit composant (4) est retenu dans un magasin à composants (15,15a) sur ladite base (100) avant d'être retenu par lesdits moyens de retenue (3).

25. Procédé selon l'une quelconque des revendications 21 à 24, dans lequel ladite base (3) supporte un panneau (5), et ledit composant (4) est transporté jusqu'audit panneau (5) après l'examen dudit composant par ledit dispositif de formation d'images (6).

26. Procédé selon la revendication 25, dans lequel ledit au moins un composant optique (8) est déplacé jusqu'à une autre position dans laquelle un trajet optique est défini entre ledit dispositif de formation d'images (6) et ledit panneau (5) par l'intermédiaire dudit au moins un composant optique (8), pendant le transport dudit composant (4) jusqu'audit panneau (5).
